# EUROPÄISCHE PATENTSCHRIFT

(11) **EP 1 281 937 B1**
(45) Veröffentlichungstag und Bekanntmachung des Hinweises auf die Patenterteilung: **25.02.2015**
(21) Anmeldenummer: 02015051.2
(22) Anmeldetag: 05.07.2002
(51) Int. Cl.: B60K 37/00

(54) **Elektronikmodul**
Electronic module
Module électronique

(30) Priorität: 03.08.2001 DE 10138170
(43) Veröffentlichungstag der Anmeldung: 05.02.2003
(73) Patentinhaber: ROBERT BOSCH GMBH, 70442 Stuttgart (DE)
(72) Erfinder: Preissl, Reinhold, 70439 Stuttgart (DE)

(56) Entgegenhaltungen:
- EP-A2- 0 511 010
- WO-A-98/35856
- DE-C1- 19 650 468
- DE-C1- 19 820 337
- US-A- 5 255 155
- US-A- 6 166 450

## Beschreibung

### Stand der Technik

Die Erfindung geht aus von einem Elektronikmodul nach der Gattung des Hauptanspruchs. Aus der US 5,255,155 ist schon eine Anordnung einer Folienleiterplatte auf der Rückseite einer Instrumententafel bekannt, bei der die Ansteuerung eines Anzeigeinstruments, ein Autoradio und Bedientasten miteinander über eine flexible Leiterplattenfolie und darauf aufgebrachte Leiterbahnen verbunden sind. Die Instrumententafel wird ähnlich einem herkömmlichen Anzeigeinstrument vor dem Fahrer und insbesondere oberhalb des Lenkrads des Fahrzeugs eingesetzt.

Aus der DE 196 50 468 C1 ist ein Verfahren zur Herstellung einer Folientastatur bekannt. Die Folientastatur besteht im wesentlichen aus einer frontseitigen Tastfolie mit Tastfeldern, denen jeweils ein Kontaktelement zugeordnet ist. Die Tastfolie wird zusammen mit einem Trägerelement, das jeweils Leiterbahnen aufweist, als Folienlaminat in eine Kavität einer Spritzgußform eingebracht und wenigstens rückseitig in Teilbereichen oder vollständig mit Kunststoff hinterspritzt. Die Folientastatur beinhaltet ferner eine Anzeigeeinrichtung.

Aus der WO98/35856 ist ein Verfahren zur Herstellung eines Kabelbaums bekannt, bei dem auf einer Montageseite einer Montageunterlage eine im wesentlichen streifenförmige, dem Lauf des herzustellenden Kabelbaums zumindest abschnittsweise folgende Basisschicht aufgebracht wird, die zumindest vorübergehend an der Montageseite haftet. An der Basisschicht werden vorzugsweise mehrere im wesentlichen parallel nebeneinander angeordnete Adern fixiert. Auf die Basisschicht wird schließlich eine Deckschicht aus einem flüssigen oder geschmolzenen Kunststoffmaterial aufgesprüht oder aufgegossen.

Aus der US 6,166,450 ist ein Bedienaufbau für ein Fahrzeug bekannt, der hinter einem Mittelkonsolenmodul mit Öffnungen angeordnet ist. Über die Bedienelemente sind verschiedene Funktionen eines Audiosystems und einer Anzeige steuerbar.

Aus der EP 0 511 010 A2 ist ein Datenkommunikationssystem zur Verwendung in einem Kraftfahrzeug bekannt, das wenigstens eine Mastereinheit und wenigstens eine Slaveeinheit aufweist, die über einen Datenbus verbunden sind. Die Einheit weist ferner Bedienelemente und eine Anzeige auf. Sie ist in einem Einbauschacht in einem Kraftfahrzeug verbaut.

### Vorteile der Erfindung

Das erfindungsgemäße Elektronikmodul mit den Merkmalen des Hauptanspruchs hat demgegenüber den Vorteil, dass das Elektronikmodul an der Rückseite einer Abdeckung einer Mittelkonsole eines Fahrzeugs angeordnet ist. Hierdurch wird die Montage des Elektronikmoduls vereinfacht, da ein Einsatz nicht direkt vor dem Fahrer oberhalb einer Lenkachse, sondern zwischen Fahrer und Beifahrer an einem getrennt von der übrigen Instrumententafel verstellbaren Abdeckung der Mittelkonsole möglich ist. Ferner können ähnlich ausgebildete Elektronikmodule auch an Mittelkonsolen zwischen Passagiersitzen angeordnet werden, so dass für die dahinter sitzenden Passagiere die Elektronikmodule nutzbar sind. Durch das Zusammenfassen von Anzeigeeinheit, Steuereinheit, Bedieneinheit und elektrischen Kontakten in einem Modul wird der Verbindungsaufwand zwischen den einzelnen Modulen minimiert. Die Mittelkonsole bietet dabei Raum, diese Module möglichst nahe zueinander anbringen zu können, um den elektrischen Verbindungsaufwand weiter zu verringern, um einerseits Material zu sparen und andererseits elektromagnetische Abstrahlungen zu verringern.

Erfindungsgemäß ist, das Elektronikmodul auf einen Leiterplattenverbund aufzubringen, der an die Form der Mittelkonsole anpassbar ist. Hierdurch kann ein Elektronikmodul in verschieden geformten Mittelkonsolen eingesetzt werden, wobei die einzelnen Leiterplatten vorzugsweise durch flexible Leiter verbunden sind. Durch ein doppelseitiges Aufbringen von elektronischen Bauteilen auf die Leiterplatten kann dabei Bauraum eingespart werden.

Durch die in den Unteransprüchen aufgeführten Maßnahmen sind vorteilhafte Weiterbildungen und Verbesserungen des im Hauptanspruch angegebenen Elektronikmoduls möglich. Weiterhin ist vorteilhaft, an der Bedieneinheit Folientasten anzuordnen, so dass die Bedieneinheit in eine der Leiterplatten oder in die Abdeckung der Mittelkonsole integriert werden kann, da hierdurch auf die zusätzliche Anordnung einer gesonderten Bedieneinheit verzichtet werden kann.

Weiterhin ist vorteilhaft, das Elektronikmodul an der Abdeckung einzugießen oder einzuschäumen, da hierdurch eine einfache und sichere Halterung des Elektronikmoduls möglich ist, ohne zusätzliche Schrauben oder Bohrungen anbringen zu müssen.

Weiterhin ist vorteilhaft, zwischen dem Elektronikmodul und der Instrumententafel eine elektromagnetische Abschirmschicht anzuordnen, da hierdurch einerseits die elektromagnetische Abstrahlung in den Fahrgastraum und andererseits auch in einen Bereich außerhalb des Fahrzeugs vermieden werden kann.

Es ist ferner vorteilhaft, an dem Elektronikmodul ein Datenträgerlaufwerk anzuordnen, in das durch eine Öffnung in der Mittelkonsole ein Datenträger eingelegt werden kann. Hierdurch ist das Abspielen insbesondere eines Musikdatenträgers möglich, ohne zusätzlich ein Datenträgerlaufwerk z.B. in einem Kofferraum eines Fahrzeugs oder in einem hierfür erforderlichen Einbauschacht vorzusehen.

Weiterhin ist vorteilhaft, an den elektrischen Kontakten Sicherungen und/oder Relais vorzusehen, da diese an der Position der Mittelkonsole des Fahrzeugs für einen Benutzer des Fahrzeugs leicht zugänglich und damit im Fall eines Defekts einer Sicherung oder eines Relais leicht auffindbar und austauschbar sind.

Weiterhin ist vorteilhaft, eine Zugangs- und/oder Startkontrolleinrichtung an dem Elektronikmodul vorzusehen, da hierdurch auf die Anordnung eines Zündschlosses oder von Fahrzeugschlössern verzichtet werden kann.

Weiterhin ist vorteilhaft, eine Kommunikationseinheit, z.B. ein Autoradio oder eine Mobilfunkeinheit, in das Elektronikmodul zu integrieren, da hierdurch auf die Anordnung von weiteren Einbauschächten für diese Geräte verzichtet werden kann.

### Zeichnung

Ausführungsbeispiele der Erfindung sind in der Zeichnung dargestellt und in der nachfolgenden Beschreibung näher erläutert. Es zeigen Figur 1 einen Aufbau eines erfindungsgemäßen Elektronikmoduls, Figur 2 eine Seitenansicht eines in einer Mittelkonsole eingebauten erfindungsgemäßen Elektronikmoduls, Figur 3 eine Aufsicht auf eine Mittelkonsole enthaltend ein erfindungsgemäßes Elektronikmodul, Figuren 4a und 4b Ausführungsbeispiele für die Anordnung von Folientasten an der Abdeckung der Mittelkonsole.

### Beschreibung des Ausführungsbeispiels

Das erfindungsgemäße Elektronikmodul kann in einer Vielzahl von Fahrzeugen eingesetzt werden, z.B. bei Flugzeugen, Schiffen, Schienenfahrzeugen oder Kraftfahrzeugen. Einerseits kann es in einem Bereich eines Fahrzeugführers, andererseits aber auch in einem Passagierbereich eingesetzt werden. Die Mittelkonsole trennt dabei z.B. einen Fahrer und einen Beifahrer oder aber zwei Sitze, die sich vor einem Passagier des Fahrzeugs befinden. Im Folgenden ist das erfindungsgemäße Elektronikmodul am Beispiel einer Verwendung in einer Mittelkonsole eines Kraftfahrzeugs erläutert.

In einer bevorzugten Ausführungsform umfasst das Elektronikmodul zumindest eine Anzeigeeinheit, eine Steuereinheit, eine Bedieneinheit und weitere elektronische Kontakte.

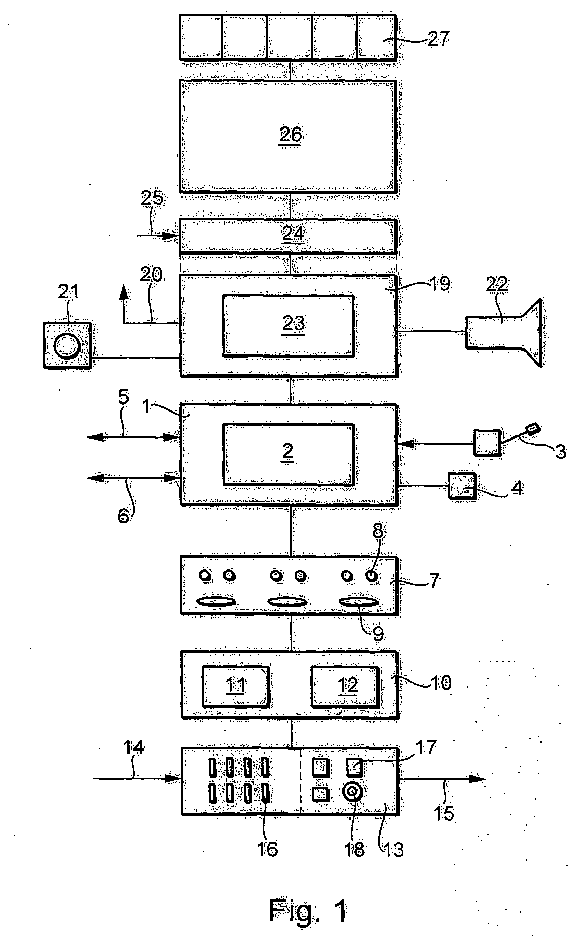

In der Figur 1 ist ein prinzipieller Aufbau eines erfindungsgemäßen Elektronikmoduls dargestellt. An einer Steuereinheit 1 ist eine Recheneinheit 2 angeordnet, die der Steuerung der übrigen Komponenten des Elektronikmoduls, der Erfassung von Signalen externer Bedienelemente, wie z.B. einem Lenkradschalter 3 und der Erfassung von Fahrzeugsensoren 4 dient. Ferner dient die Recheneinheit 2 auch zur Kommunikation mit weiteren Fahrzeugfunktionen über einen ersten Fahrzeugdatenbus 5. Vorzugsweise ist ein zweiter Fahrzeugdatenbus 6 an die Steuereinheit 1 angeschlossen, wobei der erste Fahrzeugdatenbus 5 mit den Antrieb des Fahrzeugs betreffenden Funktionen verbunden ist. Hierzu ist der erste Fahrzeugdatenbus 5 vorzugsweise als ein CAN-Bus ausgeführt (Communication Area Network). Der zweite Fahrzeugdatenbus 6, der vorzugsweise als ein optischer Datenbus ausgeführt ist, steht mit weiteren Multimediageräten im Fahrzeug in Verbindung, z.B. mit Mulitmediageräten für Passagiere im Fahrzeug. Neben der Recheneinheit 2 können noch weitere Recheneinheiten, die vorzugsweise als Mikroprozessoren ausgeführt sind, an der Steuereinheit 1 angeordnet sein. Die Steuereinheit 1 ist mit einer Bedieneinheit 7 verbunden, auf der insbesondere Drucktasten 8 angeordnet sind. Ferner können auch Kipptasten 9, Schieberegler oder sonstige Bedienelemente an der Bedieneinheit 7 angeordnet sein. Die Bedieneinheit 7 dient der Steuerung der über das Elektronikmodul ansteuerbaren Fahrzeugfunktionen. Weiterhin besteht eine Verbindung der Steuereinheit 1 zu einer Zugangssteuerungseinheit 10 des Fahrzeugs, die eine Zugangskontrolleinrichtung 11 zur Kontrolle-eines schlüssellosen Zugangs in das Fahrzeug umfasst. Ferner umfasst die Zugangssteuerungseinheit 10 eine Startkontrolleinrichtung 12, die vorzugsweise berührungslos die Berechtigung eines Fahrers zur Benutzung des Fahrzeugs überprüft, vorzugsweise durch einen Funkkontakt zu einer Chipkarte. Über eine derartige Berechtigungskarte, die von einem Fahrer mitgeführt wird, wird eine Funkverbindung einerseits zu der Zugangskontrolleinrichtung 11 und/oder zu der Startkontrolleinrichtung 12 hergestellt. Einerseits können damit Fahrzeugtüren geöffnet und verschlossen werden und andererseits kann der Motor des Fahrzeugs gestartet werden.

Ferner umfasst das Elektronikmodul eine Kontakteinheit 13, die über eine Spannungszuführung 14 eine Betriebsspannung des Elektronikmoduls von einem in der Figur 1 nicht dargestellten Akkumulator des Fahrzeugs erhält. Über einen Leistungsausgang 15 werden in der Figur 1 nicht gezeigte Fahrzeugfunktionen mit einer Betriebsspannung versorgt, z.B. eine Fahrzeugbeleuchtung, ein elektrischer Fensterheber und/oder eine Klimaanlage im Fahrzeug. An der elektrischen Kontakteinheit 13 sind elektrische Sicherungen 16 zur Vermeidung von Überspannungen in einem Stromkreislauf des Fahrzeugs und elektrische Relais 17 insbesondere zur Ansteuerung der Fahrzeugbeleuchtung, wie z.B. eines Fahrzeugblinkers, angeordnet. Ferner ist ein Steckeranschluss 18 zum Anschließen weiterer elektrischer Geräte in dem Fahrzeug an der elektrischen Kontakteinheit 13 angeordnet. Die elektrische Kontakteinheit 13 ist vorzugsweise in einem unteren Bereich der Mittelkonsole angeordnet, wobei zumindest die Sicherungen 16 und die Relais 17 vorzugsweise von einer Klappe gegenüber dem Fahrzeuginnenraum abgedeckt sind.

Weiterhin umfasst das Elektronikmodul eine Radioeinheit 19, die mit einer Antenne 20, einem Datenträgerlaufwerk 21 und einem Lautsprecher 22 verbunden ist. Die Radioeinheit 19 umfasst eine Empfangseinheit 23, die mit einer elektromagnetischen Abschirmkappe versehen ist, um die übrigen elektronischen-Bauteile des Elektronikmoduls und weitere Fahrzeugbauteile vor elektromagnetischer Strahlung zu schützen. Von der Empfangseinheit 23 wird ein über die Antenne 20 empfangenes Radiosignal zu einem Audiosignal verarbeitet und über den Lautsprecher 22 ausgegeben. Ferner werden von der Radioeinheit auch Musikdaten, die von dem Datenträgerlaufwerk 21 gelesen werden, über den Lautsprecher 22 ausgegeben. Optional ist die Radioeinheit 19 an eine Videoeinheit 24 angeschlossen, die ein über einen Videoeingang 25 oder ein über die Antennen 20 empfangenes Fernsehsignal in ein Videobild umwandelt, das in einer Anzeige 26 dargestellt wird. Über den Videoeingang 25 sind z.B. die Ausgangssignale eines extern anzuschließenden Videoabspielgeräts mit einem Bilddatenträger zuführbar. Die Anzeige 26 ist vorzugsweise als eine Flüssigkristallanzeige ausgeführt. Ferner ist auch eine Ausführung als eine Lumineszenzanzeige möglich, wobei vorzugsweise eine flache Ausführung der Anzeige 26 zu realisieren ist, damit das Elektronikmodul auch im Bereich der Anzeige möglichst nur wenig über die Abdeckung der Mittelkonsole hinausragt. Ferner sind Warnleuchten 27 an dem Elektronikmodul angeordnet, die einzeln elektrisch ansteuerbar sind und die auf Fahrzeugfehlfunktionen hinweisen.

Die gesamten, das Elektronikmodul umfassenden Baueinheiten werden vorzugsweise von der Steuereinheit 1 angesteuert. Je nach geometrischer Ausführung der Mittelkonsole können alle genannten Baueinheiten auf einer Leiterplatte zusammengefasst werden. Ferner ist auch möglich, je nach geometrischer Ausführung der Mittelkonsole, verschiedene Baugruppen auf einer Leiterplatte zusammenzufassen und den aus diesen Leiterplatten entstehenden Leiterplattenverbund vorzugsweise mit flexiblen Leiterbahnen, die mit den einzelnen Leiterplatten verbunden werden, zu verbinden. In einem weiteren Ausführungsbeispiel kann die Leiterplatte auch als eine flexible Leiterplatte ausgeführt werden. Die einzelnen genannten Bauteile sind dabei räumlich möglichst nah zueinander auf der Rückseite der Abdeckung der Mittelkonsole anzuordnen, so dass die elektrischen Verbindungen zwischen den Bauteilen minimiert werden können.

In der Anzeige 26 werden über die Fahrzeugsensoren 4 Fahrzeugdaten angezeigt, z.B. eine Fahrzeuggeschwindigkeit, eine Motordrehzahl, eine Kühlwassertemperatur oder ein Batterieladezustand. Die Anzeige 26 wird dabei von der Recheneinheit 2 der Steuereinheit 1 angesteuert. In einem weiteren, in der Figur 1 nicht dargestellten Ausführungsbeispiel ist ein Fahrzeugnavigationssystem zur Führung eines Fahrzeugs in einem Straßennetz und/oder eine Mobilfunktelefoneinheit zur Herstellung einer Mobilfunkverbindung mit einem Mobilfunktelefonnetz in die Radioeinheit 19 integriert. Eine Spracheingabe erfolgt dabei über ein mit der Radioeinheit 19 zu verbindendes Mikrofon.

Das Datenträgerlaufwerk 21 ist vorzugsweise als ein Laufwerk für optische Datenträger, z.B. für Compact Discs, ausgeführt. Die einzelnen Elemente des Elektronikmoduls sind dabei in einem ersten Ausführungsbeispiel in der Weise verbunden, dass jeweils miteinander kommunizierende Teile des Elektronikmoduls über hierfür vorgesehenen Leiterbahnen verbunden sind, die gegebenenfalls an nicht betroffenen Komponenten vorbeigeführt werden können. Erfindungsgemäß kommunizieren die Teile des Elektronikmoduls über ein internes Bussystem, das von der Steuereinheit 1 geleitet wird.

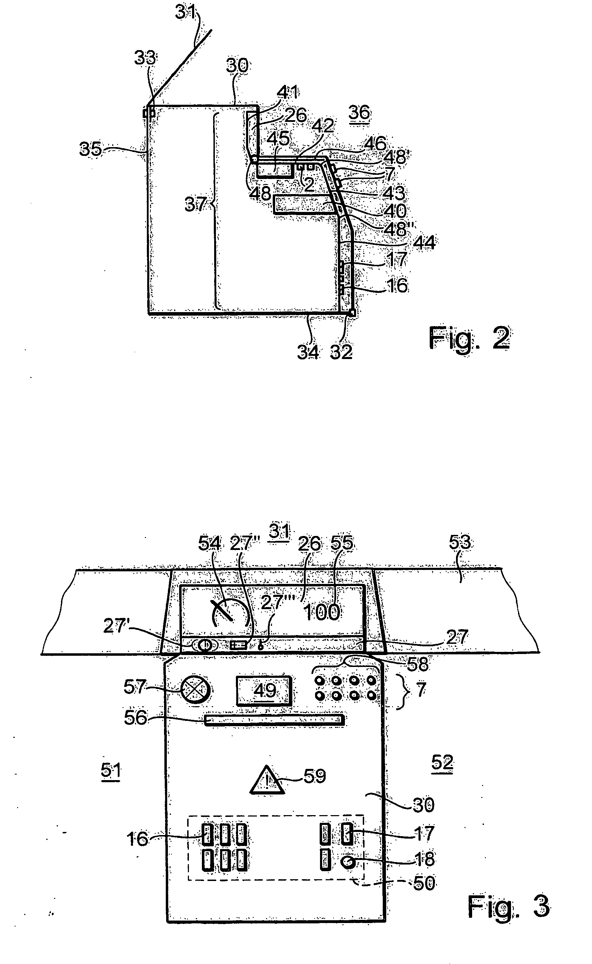

In der Figur 2 ist eine Seitenansicht eines erfindungsgemäßen Elektronikmoduls eingebaut in eine Mittelkonsole dargestellt. Eine Abdeckung 30 der Mittelkonsole ist in eine Instrumententafel des Fahrzeugs zwischen einem Fahrer und einem Beifahrer des Fahrzeugs unterhalb einer Windschutzscheibe 31 eingelassen. Die Abdeckung 30 ist durch ein erstes Befestigungselement 32 mit einem Fahrzeugboden 34 und durch ein zweites Befestigungselement 33 mit einer Spritzwand 35 verbunden, die den Passagierraum des Fahrzeugs von einem Motorraum des Fahrzeugs trennt. In einem bevorzugten Ausführungsbeispiel ist das zweite Befestigungselement 33 lösbar gestaltet, so dass die Abdeckung der Mittelkonsole in einem als Gelenk ausgeführten ersten Befestigungselement 32 in den Fahrzeugraum hineinklappbar ist, so dass Elemente eines an der vom Fahrzeuginnenraum 36 abgewandten Seite der Abdeckung 30 angeordneten Elektronikmoduls 37 ausgetauscht oder ergänzt werden können. Hier und im Folgenden bezeichnen die gleichen Bezugszeichen auch die gleichen Elemente. Die Anzeige 26 ist an einer ersten Leiterplatte 41, die Radioeinheit 19, die Recheneinheit 2 sind an einer zweiten Leiterplatte 42 und die Bedieneinheit 7 ist an einer dritten Leiterplatte 43 angeordnet, unterhalb der auch ein Datenträgerlaufwerk 40 angeordnet ist. Die Zugangssteuerungseinheit 10 und die elektrische Kontakteinheit 13 sind an einer vierten Leiterplatte 44 angeordnet. Die Empfangseinheit 23 ist durch eine elektromagnetische Abschirmhaube 45 auf der von dem Fahrzeuginnenraum abweisenden Seite der Abdeckung 30 umgeben und damit abgeschirmt. Eine Abschirmung gegenüber dem Fahrzeugraum wird durch eine auf die Abdeckung 30 aufgebrachte elektromagnetische Abschirmfolie 46 realisiert. Die einzelnen Leiterplatten 41, 42, 43, 44 sind durch flexible Leiterelemente 48, 48', 48'' miteinander verbunden. In einem weiteren Ausführungsbeispiel werden mehrere oder alle Leiterplattenteile aus einer Gesamtleiterplatte erstellt. Hierbei wird die Gesamtleiterplatte zunächst als ein einziges Leiterplattenstück gefertigt und vorzugsweise auch mit elektrischen Bauteilen bestückt. Anschließend werden Bereiche der Leiterplatte zwischen den Leiterplattenteilen, die den einzelnen Leiterplatten, z.B. den einzelnen Leiterplatten 41, 42; 43 und 44 entsprechen, in ihrer Dicke verringert, so dass die Leiterplatte in diesen Bereichen biegbar wird. In einer bevorzugten Ausführungsform wird die Dicke der Leiterplatte in diesem Bereich auf 0,2 mm verringert, während die übrige Leiterplatte z.B. 1,5 mm dick ist. Dies kann z.B. durch ein Herausfräsen oder ein Abtragen z.B. mittels Laserlicht erfolgen. In einer bevorzugten Ausführungsform wird eine Rillenstruktur in die Leiterplatte eingebracht. Die Rillenstruktur wird vorzugsweise auf der den auf der Leiterplatte angeordneten Leiterbahnen abgewandten Seite der Leiterplatte eingebracht, so dass die Leiterbahnen für eine elektrische Leitung erhalten bleiben und die einzelnen Leiterplattenteile miteinander elektrisch verbinden. Nach dem Einbringen z.B. der Rillen in die Leiterplatte kann die Leiterplatte in der Mittelkonsole eingebracht und an die Form der Mittelkonsole angepasst werden. Auf das Anbringen von flexiblen Leiterbahnen zwischen einzelnen Leiterplattenteilen kann hierdurch verzichtet werden, so dass die Montagezeit und die Anzahl von Kontaktstellen reduziert sowie auf das Anringen von Steckern verzichtet werden kann.

Weitere elektronische Bauteile, z.B. aktive Bauteile wie Transistoren oder integrierte Schaltkreise sowie passive Bauelemente wie Widerstände oder Kondensatoren sind vorzugsweise in einem SMD-Verfahren beidseitig auf die Leiterplatten 41, 42, 43, 44 aufgebracht und in der Figur 1 im Detail nicht dargestellt. Die Leiterplatten 41, 42, 42, 44 sind vorzugsweise durch Schraubverbindungen, durch Steckverbindungen oder durch Klebeverbindungen an der dem Fahrzeuginnenraum 36 abweisenden Seite der Abdeckung 30 befestigt. In einem weiteren, in der Figur 2 nicht dargestellten Ausführungsbeispiel können die Leiterplatten 41, 42, 43, 44 auch in die Abdeckung 30 eingegossen sein. In diesem Fall sind in dem Gussbereich Öffnungen vorzusehen, durch die Komponenten auf den Leiterplatten austauschbar sind.

In einem weiteren, ebenfalls in der Figur 2 nicht gezeigten Ausführungsbeispiel können elektrische Bauteile auch direkt auf die Rückseite der Abdeckung 30 aufgebracht werden, so dass in diesem Fall auf die Anordnung von Leiterplatten ganz oder teilweise verzichtet werden kann. Hierzu werden vorzugsweise Leiterbahnen in der Form auf die Abdeckung 30 aufgebracht, dass metallisierbare Bereiche der Abdeckung 30 geschaffen werden. Die Abdeckung 30 wird in ein Metallbad getaucht, so dass an diesen Stellen der Abdeckung 30 leitfähiges Material verbleibt und die elektrischen Bauteile verbindet.

In der Figur 3 ist eine Aufsicht auf eine erfindungsgemäße Mittelkonsole dargestellt, die zwischen dem Fussraum 51 eines Fahrers und dem Fussraum 52 eines Beifahrers in eine Instrumententafel 53 des Fahrzeugs vor der Windschutzscheibe 31 eingesetzt ist. Die Anzeige 26 ist vorzugsweise als eine frei programmierbare Anzeige ausgeführt, bei der eine Skalenanzeige 54 und eine Digitalanzeige 55 nach Ansteuerung durch die Steuereinheit 1 in den Bildpunkten der vorzugsweise als Flüssigkristallanzeige ausgeführten Anzeige 26 darstellbar sind. Unterhalb der Anzeige 26 sind Warnleuchten 27 angeordnet, z.B. eine Bremswarnleuchte 27', eine Batteriewarnleuchte 27'' und eine Temperaturwarnanzeige 27'''. Die Abdeckung 30 erstreckt sich in den Fahrzeuginnenraum 36 hinein und weist an ihrer Vorderseite eine Öffnung 56 auf, durch die ein Datenträger in das Datenträgerlaufwerk 40 eingeführt werden kann. Oberhalb des Datenträgerlaufwerks sind Bedienelemente der Bedieneinheit 7 angeordnet, z.B. eine Kreuzwippe 57 oder einzelne Drucktasten 58. Ferner kann eine zusätzliche Anzeige 49, vorzugsweise eine Balkenanzeige zur Darstellung von Radiofunktionen, an der Frontseite der Abdeckung 30 angeordnet sein. Hinter einer gestrichelt angedeuteten Klappe 50 sind die Sicherungen 16, Relais 17 und ein Steckeranschluss 18 angeordnet. Ferner ist auf der Abdeckung zusätzlich eine Warnblinkanlagentaste 59 gut sichtbar für Fahrer und Beifahrer angeordnet. Die Abdeckung 30 ist vorzugsweise von der Instrumententafel 53 abklappbar, so dass die durch seitliche Schutzwände, die in der Figur 3 nicht eingezeichnet sind, von den Fussräumen 51, 52 getrennte Mittelkonsole in den Fahrzeuginnenraum 36 hineingeklappt und gewartet werden kann.

Die Drucktasten 58 sind vorzugsweise als Membranschalter aus Polyester oder Polycarbonatfolien ausgeführt, die vorzugsweise eine Dicke zwischen 100 und 400 µm aufweisen. Der Stromkreis durch die Kontakte ist aus elektrisch leitenden Schichten, gewöhnlich aus silber- oder kohlenstoffpräparierten Stempeln, ausgeführt und durch einen Siebdruckprozess auf die Folien aufgebracht. Eine Deckfolie, die gegebenenfalls mit verschiedenen Farben bedruckbar ist, wird mit den darüberliegenden, leitenden Folien zu einer kompakten Einheit verklebt. Die Montage der Tasten kann durch Anordnung an einer Leiterplattenmontage vereinfacht werden. Durch ein Einprägen, ein thermisches Einformen oder eine Ultraschallbearbeitung einer Kuppel in die Folie ist ein Druckpunkt einer Taste darstellbar. Die Rückstellung in eine Ausgangslage ist durch die Hinterlegung der Schalter mit einer Matte aus einem elastischen Material, z.B. aus einem Elastomer, darstellbar. Insbesondere können auch Membranschalter nach der DIN 4211 Teil 1 verwendet werden.

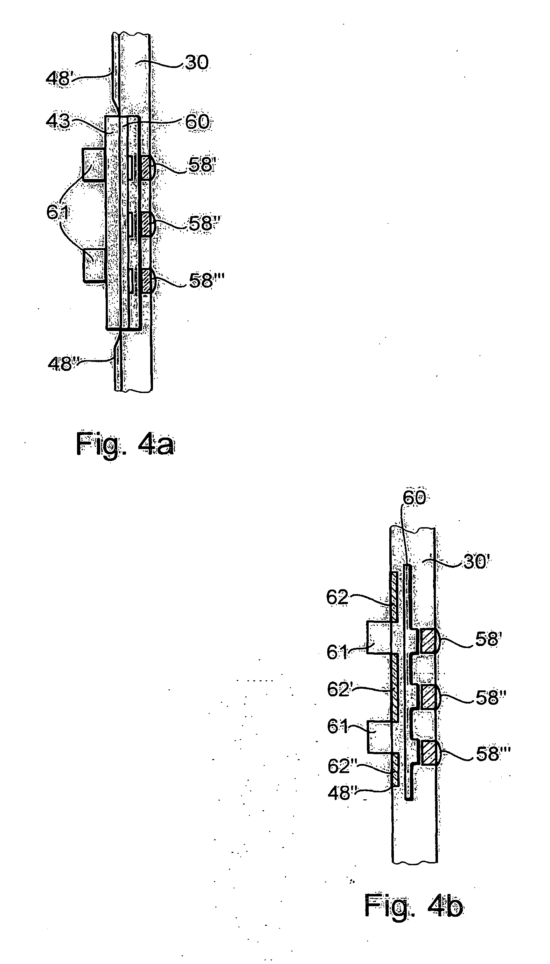

In der Figur 4a ist ein erstes Ausführungsbeispiel für eine Folientastatur dargestellt. In der Figur 4a sind Drucktasten 58', 58'' und 58''' aus der Abdeckung 30 ausgeformt. Durch die Drucktasten sind jeweils entsprechende Bereiche einer Schaltmatte 60 auslösbar, die die den Drucktasten 58', 58'' und 58''' zuweisenden elektrische Kontakte auf der dritten Leiterplatte 43 verbinden. Auf der der Abdeckung 30 abweisenden Seite der dritten Leiterplatte 43 sind elektrische Bauteile 61 angeordnet, die eine Betätigung der Drucktasten 58', 58'' und 58''' auswerten und über die flexible Leiterelemente 48', 48'' und 48''' an entsprechende Einheiten des Elektronikmoduls weiterleiten.

In der Figur 4b ist ein zweites Ausführungsbeispiel dargestellt, bei dem eine Schaltmatte 60 in eine modifizierte Abdeckung 30' eingebracht ist. Die elektrischen Bauteile 61 sind hier direkt auf die Abdeckung 30' aufgebracht, auf der ebenfalls Leiterbahnen 62 zum Verbinden der elektrischen Bauteile angeordnet sind. Über ein flexibles Leiterelement 48'' besteht eine Verbindung zu der Zugangssteuerungseinheit 10. Über die Leiterbahn 62 besteht eine elektrische Verbindung zu der Steuereinheit 1. Eine zusätzliche Leiterplatte ist in diesem Ausführungsbeispiel nicht erforderlich.

## Patentansprüche

1. Elektronikmodul in einem Fahrzeug, wobei an dem Elektronikmodul eine Anzeigeeinheit, eine Steuereinheit eine Bedieneinheit und elektrische Kontakte angeordnet sind, wobei das Elektronikmodul (37) auf der Rückseite einer Abdeckung (30) einer Mittelkonsole des Fahrzeugs angeordnet ist, dass die Teile des Elektronikmoduls (37) über ein internes Bussystem kommunizieren, das von der Steuereinheit (1) geleitet wird, dass elektronische Bauteile des Elektronikmoduls (37) auf einem Leiterplattenverbund vorzugsweise beidseitig aufgebracht sind, **dadurch gekennzeichnet, dass** der Leiterplattenverbund an die Form der Mittelkonsole angepasst ist und dass die Leiterplatten (41, 42, 43, 44) des Leiterplattenverbundes an der einem Fahrzeuginnenraum abweisenden Seite der Abdeckung (30) der Mittelkonsole befestigt sind.

2. Elektronikmodul nach Anspruch 1, **dadurch gekennzeichnet, dass** der Leiterplattenverbund mindestens eine aus mehreren Leiterplattenbereichen bestehende Leiterplatte aufweist und dass die Leiterblattenbereiche durch einen biegbaren Bereich der Leiterplatte getrennt werden.

3. Elektronikmodul nach einem der vorhergehenden Ansprüche, **dadurch gekennzeichnet, dass** an der Bedieneinheit (7) Folientasten (8, 58) angeordnet sind und dass die Folientasten (8, 58) in die Abdeckung (30) der Mittelkonsole integriert sind.

4. Elektronikmodul nach einem der vorhergehenden Ansprüche, **dadurch gekennzeichnet, dass** das Elektronikmodul (37) an der Abdeckung (30) der Mittelkonsole eingegossen oder eingeschäumt ist.

5. Elektronikmodul nach einem der vorhergehenden Ansprüche, **dadurch gekennzeichnet, dass** zwischen dem Elektronikmodul (37) und der Abdeckung (30) eine elektromagnetische Abschirmschicht (42) angeordnet ist.

6. Elektronikmodul nach einem der vorhergehenden Ansprüche, **dadurch gekennzeichnet, dass** an dem Elektronikmodul (37) ein Datenträgerlaufwerk (40) angeordnet ist und dass in der Mittelkonsole eine Öffnung (58) zum Einlegen eines Datenträgers angeordnet ist.

7. Elektronikmodul nach einem der vorhergehenden Ansprüche, **dadurch gekennzeichnet, dass** an den elektrischen Kontakten Sicherungen (16) und/oder Relais (17) einsetzbar sind.

8. Elektronikmodul nach einem der vorhergehenden Ansprüche, **dadurch gekennzeichnet, dass** die Anzeigeeinheit (26) eine Flüssigkristallanzeige oder eine Elektrolumineszenzanzeige ist.

9. Elektronikmodul nach einem der vorhergehenden Ansprüche, **dadurch gekennzeichnet, dass** eine Zugangskontrolleinrichtung (11) und/oder eine Startkontrolleinrichtung (12) an dem Elektronikmodul (37) angeordnet sind.

10. Elektronikmodul nach einem der vorhergehenden Ansprüche, **dadurch gekennzeichnet, dass** eine Kommunikationseinheit, insbesondere ein Autoradio (23) und/oder eine Mobiltelefoneinheit an dem Elektronikmodul angeordnet sind.

## Claims

1. Electronic module in a vehicle, wherein a display unit, a control unit, an operating unit and electrical contacts are arranged on the electronic module, wherein the electronic module (37) is arranged on the rear side of a cover (30) of a central console of the vehicle, wherein the parts of the electronic module (37) communicate via an internal bus system, which is directed by the control unit (1), wherein electronic components of the electronic module (37) have been applied to a composite circuit board assembly, preferably on both sides, **characterized in that** the composite circuit board assembly is adapted to the form of the central console and **in that** the circuit boards (41, 42, 43, 44) of the composite circuit board assembly are attached to the side of the cover (30) of the central console that is facing away from a passenger compartment of the vehicle.

2. Electronic module according to Claim 1, **characterized in that** the composite circuit board assembly has at least one circuit board consisting of multiple circuit board regions and **in that** the circuit board regions are separated by a flexible region of the circuit board.

3. Electronic module according to one of the preceding claims, **characterized in that** membrane keys (8, 58) are arranged on the operating unit (7) and **in that** the membrane keys (8, 58) are integrated in the cover (30) of the central console.

4. Electronic module according to one of the preceding claims, **characterized in that** the electronic module (37) is integrally moulded or foamed on the cover (30) of the central console.

5. Electronic module according to one of the preceding claims, **characterized in that** an electromagnetic shielding layer (42) is arranged between the electronic module (37) and the cover (30).

6. Electronic module according to one of the preceding claims, **characterized in that** a data carrier drive (40) is arranged on the electronic module (37) and **in that** an opening (58) for loading a data carrier is arranged in the central console.

7. Electronic module according to one of the preceding claims, **characterized in that** fuses (16) and/or relays (17) can be fitted on the electrical contacts.

8. Electronic module according to one of the preceding claims, **characterized in that** the display unit (26) is a liquid-crystal display or an electroluminescent display.

9. Electronic module according to one of the preceding claims, **characterized in that** an access control device (11) and/or a starting control device (12) are arranged on the electronic module (37).

10. Electronic module according to one of the preceding claims, **characterized in that** a communication unit, in particular a car radio (23) and/or a mobile phone unit, are arranged on the electronic module.

## Revendications

1. Module électronique dans un véhicule, une unité d'affichage, une unité de pilotage, une unité de commande et des contacts électriques étant disposés au niveau du module électronique, le module électronique (37) étant disposé sur le côté arrière d'un cache (30) d'un tableau de bord central du véhicule, les parties du module électronique (37) communiquant via un système de bus interne, commandé par l'unité de commande (1), les composants électroniques du module électronique (37) étant placés de préférence des deux côtés sur un assemblage de plaques conductrices, **caractérisé en ce que** l'assemblage de plaques conductrices est adapté à la forme du tableau de bord central et que les plaques conductrices (41, 42, 43, 44) de l'assemblage de plaques conductrices sont fixées au niveau du côté du cache (30) du tableau de bord central opposé à l'habitacle du véhicule.

2. Module électronique selon la revendication 1, **caractérisé en ce que** l'assemblage de plaques conductrices comporte au moins une plaque conductrice composée de plusieurs zones de plaque conductrice et que les zones de plaque conductrice sont séparées par une zone flexible de la plaque conductrice.

3. Module électronique selon l'une quelconque des revendications précédentes, **caractérisé en ce que** des touches à effleurement (8, 58) sont disposées au niveau de l'unité de commande (7) et que les touches à effleurement (8, 58) sont intégrées dans le cache (30) du tableau de bord central.

4. Module électronique selon l'une quelconque des revendications précédentes, **caractérisé en ce que** le module électronique (37) est coulé ou moussé au niveau du cache (30) du tableau de bord central.

5. Module électronique selon l'une quelconque des revendications précédentes, **caractérisé en ce qu'**une unité de blindage électromagnétique (42) est disposée entre le module électronique (37) et le cache (30).

6. Module électronique selon l'une quelconque des revendications précédentes, **caractérisé en ce qu'**un lecteur de support de données (40) est disposé au niveau du module électronique (37) et qu'une ouverture (58) est disposée dans le tableau de bord central pour insérer le support de données.

7. Module électronique selon l'une quelconque des revendications précédentes, **caractérisé en ce que** des fusibles (16) et/ou des relais (17) peuvent être insérés au niveau des contacts électriques.

8. Module électronique selon l'une quelconque des revendications précédentes, **caractérisé en ce que** l'unité d'affichage (26) est un affichage à cristaux liquides ou un affichage électroluminescent.

9. Module électronique selon l'une quelconque des revendications précédentes, **caractérisé en ce qu'**un dispositif de contrôle d'accès (11) et/ou un dispositif de contrôle de démarrage (12) sont disposés au niveau du module électronique (37).

10. Module électronique selon l'une quelconque des revendications précédentes, **caractérisé en ce qu'**une unité de communication, notamment un autoradio (23) et/ou une unité de téléphone mobile, sont disposés au niveau du module électronique.
